# DEMANDE DE BREVET EUROPEEN

(11) **EP 1 876 632 A1**
(43) Date de publication de la demande: **09.01.2008**
(21) Numéro de dépôt: 07109894.1
(22) Date de dépôt: 08.06.2007
(51) Int. Cl.: H01J 37/32

(54) **DISPOSITIF DE CONFINEMENT DU PLASMA**

(30) Priorité: 07.07.2006 FR 0652853
(71) Demandeur: Alcatel Lucent, 75008 Paris (FR)
(72) Inventeur: PUECH, Michel, 74370, METZ-TESSY (FR)
(74) Mandataire: Sciaux, Edmond

(57) **Abrégé**

Selon l'invention, le dispositif de confinement magnétique et statique du plasma dans une enceinte comprend, placées autour de la paroi périphérique de l'enceinte, une première série de premiers barreaux longitudinaux aimantés (12a-12f) présentant leur pôle nord (N) vers la paroi périphérique d'enceinte, et une seconde série de seconds barreaux longitudinaux aimantés (13a-13f) présentant leur pôle sud (S) vers la paroi périphérique d'enceinte, les séries (12a-12f ; 13a-13f) étant alternées autour de la paroi périphérique d'enceinte. Les seconds barreaux longitudinaux aimantés (13a-13f) de la seconde série de barreaux sont plus courts. Les premiers barreaux longitudinaux aimantés (12a-12f) successifs de la première série de barreaux sont reliés les uns aux autres selon leurs extrémités par des aimants permanents transversaux (15a-15f ; 16a-16f) qui forment des cadres. Cette disposition permet de boucler les lignes de champ sur le sommet et le fond de l'enceinte, évitant la dérive radiale du plasma,

## Description

La présente invention concerne les sources de plasma telles que celles qui sont utilisées dans des réacteurs à plasma pour un procédé de dépôt ou de gravure assisté par plasma. L'invention concerne plus spécialement les dispositifs destinés à confiner le plasma pour en augmenter la densité et l'homogénéité.

Un réacteur à plasma pour la mise en oeuvre d'un procédé de dépôt ou de gravure assisté par plasma comporte généralement, comme décrit par exemple dans le document FR 2 709 397, une enceinte à vide destinée à recevoir un substrat à traiter, des moyens pour générer et maintenir dans l'enceinte à vide une atmosphère à pression réduite de gaz à ioniser, des moyens d'excitation électromagnétique pour exciter les atomes de gaz à ioniser dans l'enceinte à vide et pour générer ainsi un plasma. Les moyens d'excitation électromagnétique agissent dans une partie supérieure de l'enceinte, à section réduite, constituant une zone d'excitation. Par exemple, pour une excitation du type à couplage inductif (ICP), une antenne extérieure entoure la paroi de l'enceinte à vide dans la zone d'excitation, et est alimentée par un générateur électrique radiofréquence de puissance.

On cherche généralement à produire une densité ionique élevée à basse pression, dans le plasma. Toutefois, le profil radial de la densité ionique, dans la zone d'excitation, n'est pas uniforme.

Afin de produire un profil de densité ionique plus uniforme au niveau du substrat à traiter, ce dernier est placé à l'écart de la zone d'excitation, dans la partie inférieure de l'enceinte, à section plus grande, constituant une zone de diffusion. Dans la zone de diffusion, le plasma de diffusion a une densité ionique réduite, mais plus homogène. Le plasma de diffusion a une densité ionique très fortement diminuée pour les gaz électronégatifs tels que SF₆, C₂F₆ ou CL₂ pour lesquels la densité chute rapidement en fonction de la pression (au-delà de quelques 10⁻³ mbar) et en fonction de la distance source/substrat. Or de tels gaz sont typiquement utilisés à des pressions supérieures à 10⁻² mbar pour la gravure profonde et rapide (R6E : Reactive Ion Etching), ou pour le dépôt en phase vapeur assisté par plasma (PECVD).

Afin de palier à l'inconvénient d'une chute trop rapide de la densité du plasma de diffusion, on a jusqu'à présent, notamment dans le document FR 2 709 397. prévu un dispositif de confinement magnétique statique dans la zone de diffusion de l'enceinte à vide du réacteur. Un tel dispositif de confinement est jusqu'à présent réalisé sous forme d'une série de barreaux aimantés disposés verticalement autour de la paroi périphérique du réacteur. Les aimants permanents sont polarisés radialement et successivement en sens inverses les uns des autres, de façon à former un champ de confinement multipolaire pour le plasma.

On a ainsi pu augmenter la densité ionique du plasma, et améliorer également son homogénéité dans la zone de diffusion.

Toutefois, un tel dispositif de confinement magnétique du plasma n'est pas optimum. En effet, les inventeurs ont récemment constaté un inconvénient qui limite les possibilités d'application notamment dans la fabrication de certains composants à base de matériaux semi-conducteurs.

Ainsi, dans le cas de gravure très profonde, on constate certains défauts de verticalité de la gravure dans la zone périphérique du substrat Le défaut de verticalité peut être de l'ordre de 0,5° à 1°. Cela est faible, mais incompatible avec la précision qui devient actuellement nécessaire dans la réalisation de composants en gravure très profonde, tels que par exemple les capteurs d'inertie capacitifs pour accéléromètres tridirectionnels.

On considère, selon l'invention, que cet inconvénient résulte d'une insuffisance des systèmes connus de confinement de plasma par barreaux magnétiques périphériques.

L'idée qui est à la base de l'invention est que ce défaut pourrait provenir d'un déplacement des électrons du plasma, qui viennent s'enrouler autour des lignes de champ magnétique entre les barreaux successifs du dispositif de confinement et qui se perdent à l'une des extrémités de l'enceinte à vide. En effet, les électrons sont soumis à la fois à un champ magnétique B parallèle à la paroi périphérique de l'enceinte à vide, et à un champ électrique E perpendiculaire à la paroi de l'enceinte à vide. Le champ électrique E est engendré par la différence de potentiel entre le potentiel Vₚ du plasma et le potentiel zéro de la paroi de l'enceinte à vide. Le champ magnétique B est engendré par le système de confinement à barreaux aimantés. Les électrons, sous l'effet conjugué du champ magnétique B parallèle à la paroi de l'enceinte à vide et du champ électrique E perpendiculaire à la paroi de l'enceinte à vide, sont soumis à une force de dérive qui entraîne les électrons vers une des extrémités de l'enceinte à vide. Par phénomène de charge d'espace, les ions sont alors entraînés radialement vers la paroi de l'enceinte à vide. Cette dérive radiale se traduit par une déviation des ions réactifs dans la zone périphérique du substrat à traiter, puis par des pertes d'ions, qui ne sont alors plus disponibles pour la gravure et/ou le dépôt.

Le problème proposé par la présente invention est d'éliminer l'inconvénient des dispositifs de confinement et des réacteurs plasma connus, pour limiter ou annuler la déviation parasite des ions réactifs en zone périphérique du substrat à traiter.

Pour cela, la présente invention propose de modifier la géométrie des dispositifs de confinement du plasma dans la zone de diffusion, de façon à éviter la dérive des électrons jusqu'aux extrémités supérieure et inférieure de la paroi d'enceinte à vide.

Pour atteindre ces buts ainsi que d'autres, l'invention propose un dispositif de confinement du plasma dans une source de plasma limitée par une paroi périphérique étanche, perméable aux champs magnétiques et se développant autour d'une direction longitudinale, le dispositif comprenant une première série de premiers barreaux longitudinaux aimantés et une seconde série de seconds barreaux longitudinaux aimantés, polarisés radialement, les premiers barreaux longitudinaux aimantés de la première série de barreaux présentant leur pôle nord vers une première direction radiale, les seconds barreaux longitudinaux aimantés de la seconde série de barreaux présentant leur pôle sud vers ladite première direction radiale, les deux séries de barreaux étant disposées de façon alternée autour de la paroi périphérique ; selon l'invention :
- les seconds barreaux longitudinaux aimantés de la seconde série de barreaux sont plus courts que les premiers barreaux longitudinaux aimantés de la première série de barreaux,
- des aimants permanents d'une troisième série d'aimants permanents, de même polarisation que les premiers barreaux longitudinaux aimantés de la première série de barreaux, sont disposés transversalement entre les extrémités consécutives des premiers barreaux longitudinaux aimantés, à chaque extrémité longitudinale des premiers barreaux longitudinaux aimantés, formant des cadres aimantés.

Grâce à la présence des aimants permanents de la troisième série d'aimants permanents, formant des cadres, on boucle les lignes de champ sur le sommet et le fond du réacteur, ce qui permet ainsi d'éviter la dérive du plasma jusqu'aux extrémités haute et basse en piégeant les électrons.

De préférence, les aimants permanents de la troisième série d'aimants permanents sont au contact des extrémités adjacentes des premiers barreaux longitudinaux aimantés, avec lesquels ils forment un cadre aimanté continu. Les lignes de champ magnétique qui se referment sont ainsi plus régulières et continues.

Selon une réalisation simple, les barreaux longitudinaux aimantés de l'une et l'autre des deux séries de barreaux sont rectilignes, formant une cage cylindrique.

Selon une première possibilité, les aimants permanents de la troisième série d'aimants sont rectilignes.

Selon une autre possibilité, les aimants permanents de la troisième série d'aimants permanents sont conformés en arc, continu ou brisé, pour suivre la courbure de la paroi d'enceinte à vide.

Selon une troisième possibilité, les aimants permanents de la troisième série d'aimants permanents peuvent comporter un tronçon radial qui referme une extrémité de la cage cylindrique.

Le tronçon radial peut être rectiligne, ou peut être conformé en arc, selon la forme de la paroi supérieure d'enceinte à vide.

Selon un autre aspect, l'invention propose un réacteur à plasma pour un procédé de dépôt ou de gravure assisté par plasma, comportant :
une enceinte à vide destinée à recevoir un substrat à traiter,
- des moyens pour générer et maintenir dans l'enceinte à vide une atmosphère à pression réduite de gaz à ioniser,
- des moyens d'excitation électromagnétique pour exciter les atomes de gaz à ioniser dans l'enceinte à vide et pour générer ainsi un plasma,
- et un dispositif de confinement de plasma, tel que défini ci-dessus, adapté autour d'une partie de l'enceinte à vide.

D'autres objets, caractéristiques et avantages de la présente invention ressortiront de la description suivante de modes de réalisation particuliers, faite en relation avec les figures jointes, parmi lesquelles :
- la figure 1 est une vue schématique de côté en coupe d'un réacteur à plasma selon un mode de réalisation de la présente invention ;
- la figure 2 est une vue de dessus en coupe du réacteur à plasma de la figure 1 ;
- la figure 3 est une vue en perspective illustrant une structure de dispositif de confinement du plasma selon un mode de réalisation de la présente invention ; et
- la figure 4 est une vue schématique de côté illustrant une variante du dispositif de confinement de plasma selon la présente invention.

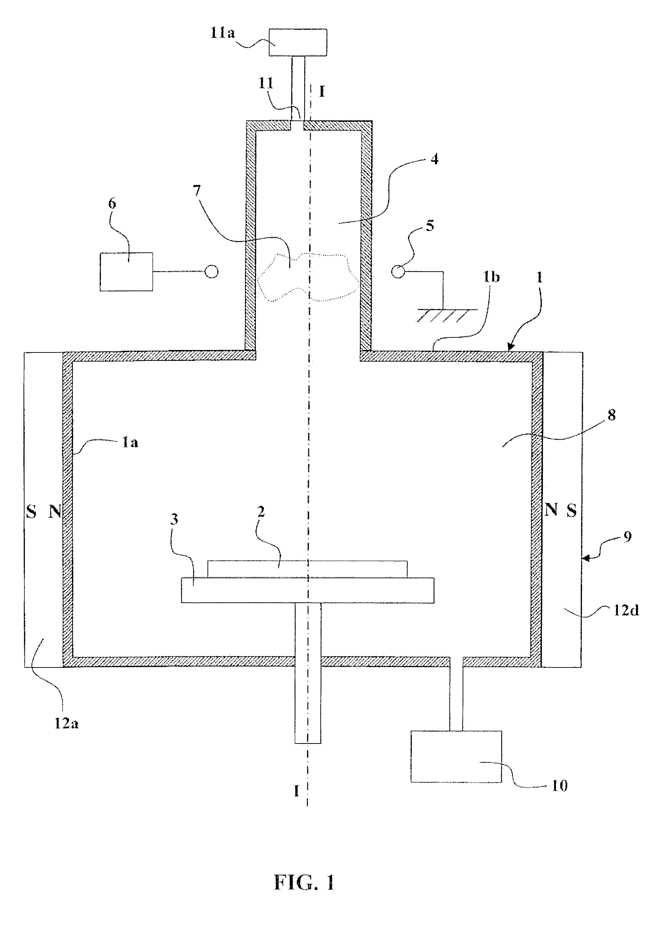

Comme on le voit sur la figure 1, un réacteur à plasma comprend essentiellement une enceinte à vide 1 destinée à contenir une atmosphère gazeuse à faible pression dans laquelle on peut introduire un substrat 2 à traiter, soutenu par un porte-substrat 3.

L'enceinte à vide 1 comprend une partie supérieure 4 à section réduite, ou zone d'excitation, dans laquelle est prévue une antenne 5 alimentée par un générateur de puissance radiofréquence 6 pour générer un plasma 7.

L'enceinte à vide 1 comprend une zone de diffusion 8, à plus grande section que la zone d'excitation 4 avec laquelle elle communique de façon permanente, laquelle zone de diffusion 8 contient le substrat 2 à traiter.

L'enceinte à vide 1 est limitée par une paroi périphérique 1a étanche, perméable aux champs magnétiques, et se développant autour d'une direction longitudinale I-I.

L'enceinte à vide 1 est raccordée à un groupe de pompage 10 qui entretient, à l'intérieur de l'enceinte à vide 1, une pression gazeuse réduite appropriée pour la génération d'un plasma, par exemple de l'ordre de 1 à 10⁻³ mbar.

Des gaz à ioniser sont introduits dans l'enceinte à vide 1 par une canalisation d'entrée de gaz 11 depuis une source de gaz 11a. Le gaz à ioniser peut par exemple être du SF₆, du C₂F₆, Cl₂, O₂, CH₄ ... , choisi en fonction du procédé à mettre en oeuvre.

Une telle structure de réacteur peut être identique à celles qui sont bien connues dans l'état de la technique, de sorte qu'il n'est pas utile de décrire en détail ses constituants.

Selon l'invention, la zone de diffusion 8 comprend un dispositif de confinement de plasma 9 à structure particulière, qui sera décrit ci-après.

Le plasma 7 généré dans la zone d'excitation 4 se diffuse vers la zone de diffusion 8 où se trouvent le substrat 2 et le porte-substrat 3. Dans la zone de diffusion 8, le plasma 7 tend à se répartir sur toute la section de la zone de diffusion 8, et il est retenu à l'écart de la paroi périphérique 1a de l'enceinte à vide 1 par le dispositif de confinement de plasma 9.

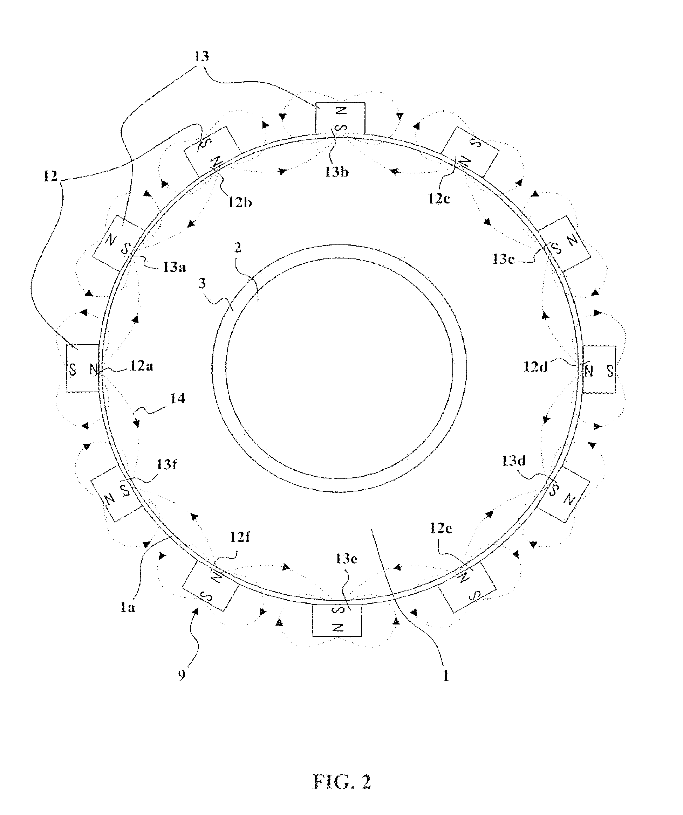

En considérant la figure 2, on voit dans cet exemple de réalisation que le dispositif de confinement de plasma 9 comprend une première série 12 de six premiers barreaux longitudinaux aimantés 12a-12f et une seconde série 13 de six seconds barreaux longitudinaux aimantés 13a-13f, polarisés radialement. Les premiers barreaux longitudinaux aimantés 12a-12f de la première série de barreaux 12 présentent leur pôle nord N orienté vers une première direction radiale ; dans l'exemple illustré, la première direction radiale est la direction centripète, orientée vers la paroi périphérique 1a de l'enceinte à vide 1. Les seconds barreaux longitudinaux aimantés 13a-13f de la seconde série de barreaux 13 présentent leur pôle sud S orienté vers ladite première direction radiale, c'est-à-dire, dans cet exemple, vers la paroi périphérique 1a de l'enceinte à vide 1. Les deux séries de barreaux longitudinaux 12 et 13 sont disposées de façon alternée autour de la paroi périphérique 1a. De la sorte, des lignes de champ magnétique, telles que la ligne 14, se développent le long de la face intérieure de la paroi périphérique 1a entre les pôles successifs nord N et sud S des barreaux successifs tels que les barreaux longitudinaux aimantés 12a et 13f.

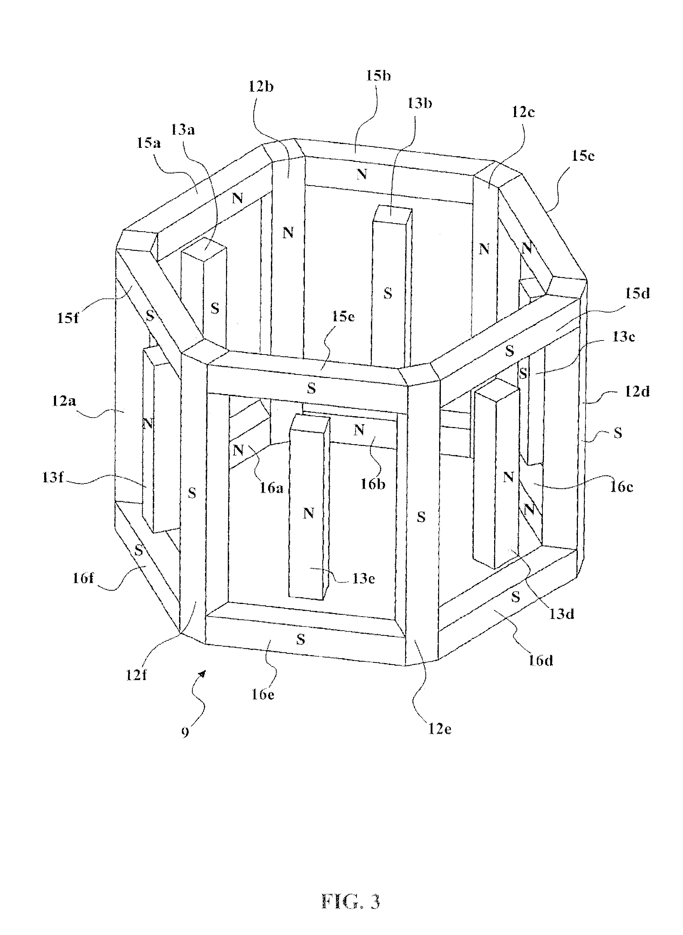

On considère maintenant la figure 3, qui illustre en perspective une structure particulière du dispositif de confinement selon un mode de réalisation de la présente invention.

On retrouve les premiers barreaux longitudinaux aimantés 12a-12f de la première série de barreaux 12, et les seconds barreaux longitudinaux aimantés 13a-13f de la seconde série de barreaux 13.

Les seconds barreaux longitudinaux aimantés 13a-13f de la seconde série de barreaux 13 sont plus courts que les premiers barreaux longitudinaux aimantés 12a-12f de la première série de barreaux 12.

On prévoit, selon l'invention, une troisième série d'aimants permanents, comprenant un premier groupe d'aimants permanents 15a, 15b, 15c, 15d, 15e et 15f d'une part, et comprenant un second groupe d'aimants permanents 16a, 16b, 16c, 16d, 16e et 16f d'autre part, dont les aimants permanents sont disposés transversalement entre les extrémités consécutives des premiers barreaux longitudinaux aimantés 12a-12f de la première série de barreaux 12, en formant des cadres aimantés.

En pratique, les aimants permanents 15a-15f du premier groupe d'aimants permanents relient les extrémités supérieures consécutives des premiers barreaux longitudinaux aimantés 12a-12f, tandis que les aimants permanents 16a-16f du second groupe d'aimants permanents relient les extrémités inférieures consécutives des premiers barreaux longitudinaux aimantés 12a-12f de la première série de barreaux 12.

Les seconds barreaux longitudinaux aimantés 13a-13f, plus courts, sont entourés par les côtés des cadres formés par les premiers barreaux longitudinaux aimantés 12a-12f et par les aimants permanents de la troisième série d'aimants permanents 15a-15f et 16a-16f, comme on le voit sur la figure 3.

Dans la réalisation illustrée sur la figure 3, les aimants permanents 15a-15f et 16a-16f de la troisième série d'aimants permanents sont au contact des extrémités adjacentes des premiers barreaux longitudinaux aimantés 12a-12f de la première série de barreaux 12, avec lesquels ils forment un cadre aimanté continu.

Les premiers barreaux longitudinaux aimantés 12a-12f de la première série de barreaux 12 sont rectilignes. De même les seconds barreaux longitudinaux aimantés 13a-13f de la seconde série de barreaux 13 sont rectilignes, et sont chacun coplanaires avec les deux premiers barreaux longitudinaux aimantés adjacents, ou légèrement déportés radialement vers l'extérieur. De la sorte, l'ensemble du dispositif de confinement de plasma 9 forme une cage cylindrique, qui est bien adaptée pour suivre au plus près la forme d'une paroi périphérique 1a cylindrique.

Les aimants permanents 15a-15f et 16a-16f de la troisième série d'aimants permanents peuvent être rectilignes, comme illustré sur la figure 3, ou peuvent avantageusement être conformés en arc brisé, constitués chacun de deux segments consécutifs orientés angulairement l'un par rapport à l'autre pour définir une forme générale quasi circulaire qui suit étroitement la forme de la paroi périphérique 1a de l'enceinte à vide 1 dans le cas d'une paroi cylindrique de révolution. En alternative, les aimants permanents 15a-15f et 16a-16f pourraient être conformés en arc.

Un dispositif de confinement tel qu'illustré sur la figure 3 est ainsi adapté pour entourer la zone de diffusion 8 d'une enceinte à vide 1 telle qu'illustrée sur les figures 1 et 2, la zone de diffusion 8 étant cylindrique.

En variante, on peut concevoir des aimants permanents 15a-15f du premier groupe d'aimants permanents de la troisième série d'aimants permanents qui recouvrent la paroi supérieure 1b de la zone de diffusion 8, les aimants permanents comportant alors un tronçon radial.

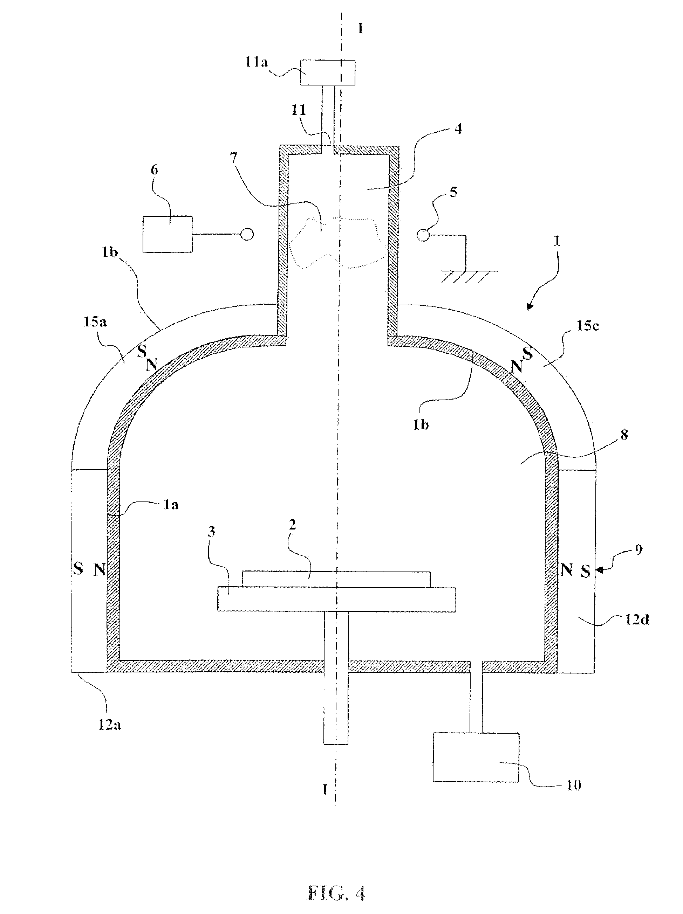

Selon une variante illustrée sur la figure 4, l'enceinte à vide 1 peut avoir une paroi supérieure 1b en voûte. Dans ce cas, les aimants permanents 15a-15f du premier groupe d'aimants permanents de la troisième série d'aimants permanents peuvent comporter un tronçon radial conformé en arc qui suit la forme en voûte de la paroi supérieure 1b de l'enceinte à vide 1.

L'ajout d'aimants permanents 15a-15f et 16a-16f de la troisième série d'aimants permanents, dans les différents modes de réalisation de l'invention, permet de refermer les lignes de champ magnétique aux extrémités des premiers barreaux longitudinaux aimantés 12a-12f, de façon que les électrons qui dérivent restent piégés sur des lignes de champ magnétique qui les maintiennent à l'intérieur de l'enceinte à vide 1 à partir des extrémités des premiers barreaux longitudinaux aimantés 12a-12f.

Les opérations de gravure profonde se trouvent ainsi considérablement améliorées, évitant les défauts de verticalité de gravure.

Des résultats similaires peuvent être obtenus en inversant le sens de polarisation de tous les aimants du dispositif de confinement de plasma 9. Dans ce cas, les premiers barreaux longitudinaux aimantés 12a-12f de la première série de barreaux 12 présentent leur pôle sud S orienté vers la paroi périphérique 1a de l'enceinte à vide 1. Les seconds barreaux longitudinaux aimantés 13a-13f de la seconde série de barreaux 13 présentent leur pôle nord N orienté vers la paroi périphérique 1a de l'enceinte à vide 1. Les deux séries de barreaux longitudinaux 12 et 13 sont disposées de façon alternée autour de la paroi périphérique 1a.

On constate par ailleurs que le dispositif de confinement selon l'invention permet en outre de réduire certains autres inconvénients des systèmes de confinement connus. En effet, dans les systèmes connus, il se produit des échauffements des parties haute et basse de la paroi du réacteur, échauffements susceptibles de dégrader certaines parties du réacteur ou d'induire une répartition inégale de température qui affecte la qualité des gravures ou des dépôts sur le substrat.

De plus, on constate des dépôts intempestifs de matière sur le haut et le fond du réacteur. Ces dépôts sont une source importante de contamination particulaire des substrats.

En utilisant le dispositif de confinement selon l'invention, on constate une réduction très sensible des dépôts de matière sur les parois haute et basse de l'enceinte à vide 1, une meilleure homogénéité du plasma dans l'enceinte à vide 1, et une réduction des effets d'échauffement parasite des extrémités supérieure et inférieure de l'enceinte à vide 1.

La présente invention n'est pas limitée aux modes de réalisation qui ont été explicitement décrits, mais elle en inclut les diverses variantes et généralisations qui sont à la portée de l'homme du métier.

## Revendications

1. - Dispositif de confinement (9) du plasma (7) dans une source de plasma limitée par une paroi périphérique (1a) étanche, perméable aux champs magnétiques et se développant autour d'une direction longitudinale (I-I), le dispositif comprenant une première série (12) de premiers barreaux longitudinaux aimantés et une seconde série (13) de seconds barreaux longitudinaux aimantés, polarisés radialement, les premiers barreaux longitudinaux aimantés (12a-12f) de la première série de barreaux (12) présentant leur pôle nord (N) vers une première direction radiale, les seconds barreaux longitudinaux aimantés (13a-13f) de la seconde série de barreaux (13) présentant leur pôle sud (S) vers ladite première direction radiale, les deux séries de barreaux (12, 13) étant disposées de façon alternée autour de la paroi périphérique (1a), **caractérisé en ce que** :
- les seconds barreaux longitudinaux aimantés (13a-13f) de la seconde série de barreaux (13) sont plus courts que les premiers barreaux longitudinaux aimantés (12a-12f) de la première série de barreaux (12),
- des aimants permanents (15a-15f ; 16a-16f) d'une troisième série d'aimants permanents, de même polarisation que les premiers barreaux longitudinaux aimantés (12a-12f) de la première série de barreaux (12), sont disposés transversalement entre les extrémités consécutives des premiers barreaux longitudinaux aimantés (12a-12f), à chaque extrémité longitudinale des premiers barreaux longitudinaux aimantés (12a-12f), formant des cadres aimantés.

2. - Dispositif selon la revendication 1, **caractérisé en ce que** les aimants permanents (15a-15f ; 16a-16f) de la troisième série d'aimants permanents sont au contact des extrémités adjacentes des premiers barreaux longitudinaux aimantés (12a-12f), avec lesquels ils forment un cadre aimanté continu.

3. - Dispositif selon l'une des revendications 1 ou 2, **caractérisé en ce que** les barreaux longitudinaux aimantés (12a-12f ; 13a-13f) de l'une et l'autre des deux séries de barreaux (12, 13) sont rectilignes, formant une cage cylindrique.

4. - Dispositif selon l'une quelconque des revendications 1 à 3, **caractérisé en ce que** les aimants permanents (15a-15f ; 16a-16f) de la troisième série d'aimants permanents sont rectilignes.

5. - Dispositif selon l'une quelconque des revendications 1 à 3, **caractérisé en ce que** les aimants permanents (15a-15f ; 16a-16f) de la troisième série d'aimants permanents sont conformés en arc, continu ou brisé.

6. - Dispositif selon l'une quelconque des revendications 1 à 3, **caractérisé en ce que** des aimants permanents (15a-15f) de la troisième série d'aimants permanents comportent un tronçon radial qui referme une extrémité de la cage cylindrique.

7. - Dispositif selon la revendication 6, **caractérisé en ce que** le tronçon radial est rectiligne.

8. - Dispositif selon la revendication 6, **caractérisé en ce que** le tronçon radial est conformé en arc.

9. - Réacteur à plasma pour un procédé de dépôt ou de gravure assisté par plasma, comportant :
- une enceinte à vide (1) destinée à recevoir un substrat (2) à traiter,
- des moyens (10) pour générer et maintenir dans l'enceinte à vide (1) une atmosphère à pression réduite de gaz à ioniser,
- des moyens (5, 6) d'excitation électromagnétique pour exciter les atomes de gaz à ioniser dans l'enceinte à vide et pour générer ainsi un plasma (7),
**caractérisé en ce qu'**une partie (8) de l'enceinte à vide (1) est munie d'un dispositif de confinement de plasma (9) selon l'une quelconque des revendications 1 à 8.
